(19)

Europäisches
Patentamt
European
Patent Office
Office européen
des brevets

(11) **EP 4 513 690 A1**

(12) **EUROPEAN PATENT APPLICATION**
published in accordance with Art. 153(4) EPC

(43) Date of publication:
**26.02.2025 Bulletin 2025/09**

(21) Application number: **23802889.8**

(22) Date of filing: **09.05.2023**

(51) International Patent Classification (IPC):
***H01S 5/065*** (2006.01)  ***H01S 3/09*** (2006.01)

(52) Cooperative Patent Classification (CPC):
**H01S 3/067; H01S 3/09; H01S 3/1106; H01S 5/065;
H01S 5/125**

(86) International application number:
**PCT/CN2023/092946**

(87) International publication number:
**WO 2023/217120 (16.11.2023 Gazette 2023/46)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **10.05.2022 CN 202210504349**

(71) Applicant: **Huawei Technologies Co., Ltd.
Shenzhen, Guangdong 518129 (CN)**

(72) Inventors:
• **LIU, Pei
Shenzhen, Guangdong 518129 (CN)**
• **ZHANG, Kai
Shenzhen, Guangdong 518129 (CN)**
• **WU, Bo
Shenzhen, Guangdong 518129 (CN)**

(74) Representative: **Maiwald GmbH
Engineering
Elisenhof
Elisenstrasse 3
80335 München (DE)**

(54) **MULTI-MODE LASER APPARATUS, LIGHT AMPLIFIER, AND LIGHT TRANSMITTING MODULE**

(57)    This application provides a multi-mode laser apparatus, applied to the optical field. The multi-mode laser apparatus includes a multi-mode laser, a mode scrambler, a mode demultiplexer, and Y Bragg gratings. The multi-mode laser is configured to generate laser light including a plurality of modes. The mode scrambler is configured to: equalize power of laser light in different modes in the laser light having the plurality of modes, and output equalized laser light. The mode demultiplexer is configured to decompose the equalized laser light into M channels of laser light in different modes. X ports of the mode demultiplexer are configured to output X channels of laser light. Y ports of the mode demultiplexer are configured to output Y channels of laser light. The Y Bragg gratings are configured to reflect the Y channels of laser light. The mode scrambler is further configured to obtain excitation laser light based on the reflected Y channels of laser light. In this application, each channel of laser light is few-mode laser light or single-mode laser light. Therefore, in this application, wavelength locking and spectral bandwidth control on multi-mode laser light can be implemented through a Bragg grating.

FIG. 1

EP 4 513 690 A1

## Description

This application claims priority to Chinese Patent Application No. 202210504349.3, filed with the China National Intellectual Property Administration on May 10, 2022 and entitled "MULTI-MODE LASER APPARATUS, OPTICAL AMPLIFIER, AND OPTICAL TRANSMIT MODULE", which is incorporated herein by reference in its entirety.

## TECHNICAL FIELD

This application relates to the field of optical communications, optical display, and optical sensing, and in particular, to a multi-mode laser apparatus, an optical amplifier, and an optical transmit module.

## BACKGROUND

A single-mode laser has excellent beam quality and fine spectral characteristics, and is widely used in the field of communication, medical treatment, and sensing. However, due to a limitation of physical conditions of the single-mode laser, output power of the current single-mode laser is still low, and costs, power consumption, a volume, or the like of the single-mode laser increase sharply with the increase of the output power.

A multi-mode laser can generate high-power laser light, and has advantages of low costs, low power consumption, and the like. However, in some application scenarios, there are high requirements on a center wavelength and a spectral bandwidth of laser light. For the single-mode laser, high-precision wavelength locking and spectral bandwidth control can be implemented through one Bragg grating. For the multi-mode laser, because a reflection wavelength of a Bragg grating is related to a mode, wavelength locking and spectral bandwidth control cannot be simply implemented. To implement the wavelength locking and the spectral bandwidth control, power of laser light in some modes in laser light can be attenuated using a waveguide taper technology, to obtain single-mode laser light. Then, the wavelength locking is implemented through the Bragg grating. However, during actual application, in the waveguide taper technology, a power loss of the laser light in some modes occurs, resulting in low power utilization.

In conclusion, how to implement the wavelength locking and the spectral bandwidth control on multi-mode laser light is a technical problem that needs to be urgently resolved currently.

## SUMMARY

This application provides a multi-mode laser apparatus, an optical amplifier, and an optical transmit module. Multi-mode laser light can be decomposed into few-mode laser light or single-mode laser light by a mode demultiplexer. Therefore, in this application, wavelength locking and spectral bandwidth control on the multi-mode laser light can be implemented through a Bragg grating.

A first aspect of this application provides a multi-mode laser apparatus. The multi-mode laser apparatus includes a multi-mode laser, a mode scrambler, a mode demultiplexer, and Y Bragg gratings. The multi-mode laser is configured to generate laser light including a plurality of modes. The mode scrambler is configured to: equalize power of laser light in different modes in the laser light having the plurality of modes, and output equalized laser light. The mode demultiplexer is configured to decompose the equalized laser light into M channels of laser light in different modes. M is an integer greater than 1. The mode demultiplexer includes M output ports. X ports of the M output ports are configured to output X channels of laser light in the M channels of laser light. Y ports of the M output ports are configured to output Y channels of laser light in the M channels of laser light. X and Y are integers greater than 0. The Y ports are connected to the Y Bragg gratings. The Y ports are in one-to-one correspondence with the Y Bragg gratings. The Y Bragg gratings are configured to: reflect the Y channels of laser light, and transmit the reflected Y channels of laser light to the mode demultiplexer. The mode demultiplexer is further configured to transmit the reflected Y channels of laser light to the mode scrambler. The mode scrambler is further configured to: obtain excitation laser light based on the reflected Y channels of laser light, and transmit the excitation laser light to the multi-mode laser. The excitation laser light is used as an excitation source of the multi-mode laser.

In an optional implementation of the first aspect, each of the Y channels of laser light includes Z modes, and Z is an integer greater than 1. When a value of M is large, a quantity of Bragg gratings can be reduced by reflecting laser light having a plurality of modes through one Bragg grating. Therefore, in this application, costs of the multi-mode laser apparatus can be reduced.

In an optional implementation of the first aspect, each of the X channels of laser light includes only one mode. When one of the X channels of laser light includes a plurality of modes, the multi-mode laser apparatus further needs to decompose the laser light having the plurality of modes into laser light having a single mode through another mode demultiplexer. Therefore, in this application, costs of the multi-mode laser apparatus can be reduced.

In an optional implementation of the first aspect, Z is between 2 and 10. For example, Z is equal to 2 or 10. A larger value of Z indicates more difficult control on a bandwidth of laser light reflected by the Bragg grating. To control the bandwidth of the laser light, Z may be limited to be between 2 and 10 in this application. Therefore, in this application, quality of the generated laser light can be improved when a quantity of Bragg gratings is reduced.

In an optional implementation of the first aspect, each of the M channels of laser light includes only one mode. A reflection wavelength of the Bragg grating is related to a quantity of modes. When the Bragg grating reflects only one mode of laser light, a wavelength of the reflected laser light can be stably controlled. Therefore, in this application, quality of the generated laser light can be improved.

In an optional implementation of the first aspect, a ratio of a quantity of modes included in the Y channels of laser light to a quantity of modes included in the M channels of laser light is between 5% and 30%. When the ratio of the quantities of modes is between 5% and 30%, output power of the multi-mode laser can be well stabilized. Therefore, in this application, quality of the generated laser light can be improved.

In an optional implementation of the first aspect, a quantity of modes of the equalized laser light is less than or equal to a quantity of modes of the laser light having the plurality of modes. Because of existence of the mode scrambler, the quantity of modes of the equalized laser light may be greater than the quantity of modes of the laser light having the plurality of modes. In this case, the quantity of modes included in the excitation laser light output by the mode scrambler is greater than the quantity of modes of the laser light generated by the multi-mode laser, resulting in a waste of power of a part of excitation laser light. Therefore, in this application, power utilization can be improved.

In an optional implementation of the first aspect, the Y Bragg gratings are waveguide Bragg gratings. Compared with a volume Bragg grating, the waveguide Bragg grating has lower costs. Therefore, in this application, costs of the multi-mode laser apparatus can be reduced.

In an optional implementation of the first aspect, reflectivity of each of the Y Bragg gratings is greater than 99%. When the reflectivity is low, the ratio of the quantity of modes of the Y channels of laser light to the quantity of modes of the M channels of laser light is large, resulting in a reduction in a quantity of modes of the X channels of laser light, in other words, a reduction in an output capability of the multi-mode laser apparatus. Therefore, in this application, through control of the reflectivity, the output capability of the multi-mode laser apparatus can be improved.

A second aspect of this application provides a multi-mode laser apparatus. The multi-mode laser apparatus includes a multi-mode laser, a mode demultiplexer, and X Bragg gratings. The multi-mode laser is configured to generate laser light including a plurality of modes. The mode demultiplexer is configured to decompose the laser light having the plurality of modes into X channels of laser light in different modes. X is an integer greater than 1. The mode demultiplexer includes X ports. The X ports are configured to output the X channels of laser light. The X ports are connected to the X Bragg gratings. The X ports are in one-to-one correspondence with the X Bragg gratings. The X Bragg gratings are configured to: reflect the X channels of laser light, and transmit the reflected X channels of laser light to the mode demultiplexer. The X Bragg gratings are further configured to: transmit the X channels of laser light, and output the transmitted X channels of laser light. The mode demultiplexer is further configured to: combine the reflected X channels of laser light to obtain excitation laser light, and transmit the excitation laser light to the multi-mode laser. The excitation laser light is used as an excitation source of the multi-mode laser. In this application, wavelength locking and spectral bandwidth control on the X channels of laser light can be implemented through the X Bragg gratings.

In an optional implementation of the second aspect, each of the X channels of laser light includes only one mode. A reflection wavelength of the Bragg grating is related to the mode. When the Bragg grating reflects only one mode of laser light, a wavelength of the reflected laser light can be stably controlled. Therefore, in this application, quality of the generated laser light can be improved.

In an optional implementation of the second aspect, the multi-mode laser apparatus further includes a mode scrambler. The mode scrambler is configured to: equalize power of laser light in different modes in the laser light having the plurality of modes, and output equalized laser light. The mode demultiplexer is configured to decompose the equalized laser light into the X channels of laser light in the different modes. The mode demultiplexer is further configured to transmit the excitation laser light to the multi-mode laser through the mode scrambler. Due to a process limitation, the power of the laser light in the different modes output by the multi-mode laser may be different. Use of the mode scrambler can equalize the power of the laser light in the different modes in the laser light having the plurality of modes, so as to equalize power of the transmitted X channels of laser light and improve quality of the output laser light.

In an optional implementation of the second aspect, a quantity of modes of the equalized laser light is less than or equal to a quantity of modes of the laser light having the plurality of modes. Because of existence of the mode scrambler, the quantity of modes of the equalized laser light may be greater than the quantity of modes of the laser light having the plurality of modes. In this case, the quantity of modes included in the excitation laser light output by the mode scrambler is greater than the quantity of modes of the laser light generated by the multi-mode laser, resulting in a waste of power of a part of excitation laser light. Therefore, power utilization can be improved by limiting the quantity of modes of the equalized laser light.

In an optional implementation of the second aspect, reflectivity of each of the X Bragg gratings is between 5% and 30%. When the reflectivity is between 5% and 30%, output power of the multi-mode laser can be well stabilized. Therefore, in this application, quality of the generated laser light can be improved.

A third aspect of this application provides an optical amplifier. The optical amplifier includes an amplifier group and the multi-mode laser apparatus according to the first aspect, any optional implementation of the first aspect, the second aspect, or any optional implementation of the second aspect. The multi-mode laser apparatus is configured to output X channels of laser light. X is an integer greater than 0. The amplifier group includes P amplifiers. P is an integer less than or equal to X and greater than or equal to $\frac{X}{2}$. The P amplifiers are configured to: receive X channels of first optical signals and the X channels of laser light, and amplify the X channels of first optical signals based on the X channels of laser light to obtain X channels of second optical signals. The X channels of laser light are in one-to-one correspondence with the X channels of first optical signals. The X channels of first optical signals are in one-to-one correspondence with the X channels of second optical signals.

A fourth aspect of this application provides an optical transmit module. The optical transmit module includes a modulator group and the multi-mode laser apparatus according to the first aspect, any optional implementation of the first aspect, the second aspect, or any optional implementation of the second aspect. The multi-mode laser apparatus is configured to output X channels of laser light. X is an integer greater than 0. The modulator group includes X modulators. The X modulators are in one-to-one correspondence with the X channels of laser light. The X modulators are configured to modulate the X channels of laser light based on an electrical signal to obtain X channels of optical signals.

A fifth aspect of this application provides a laser light generation method. The laser light generation method includes the following steps: generating laser light including a plurality of modes; equalizing power of laser light in different modes in the laser light having the plurality of modes to obtain equalized laser light; decomposing the equalized laser light into M channels of laser light in different modes, where M is an integer greater than 1; outputting X channels of laser light in the M channels of laser light; and reflecting Y channels of laser light in the M channels of laser light, where the reflected Y channels of laser light are used as an excitation source, and X and Y are integers greater than 0. In an optional implementation of the fifth aspect, each of the Y channels of laser light includes Z modes. Z is an integer greater than 1.

In an optional implementation of the fifth aspect, each of the X channels of laser light includes only one mode.

In an optional implementation of the fifth aspect, Z is between 2 and 10.

In an optional implementation of the fifth aspect, each of the M channels of laser light includes only one mode.

In an optional implementation of the fifth aspect, a ratio of a quantity of modes included in the Y channels of laser light to a quantity of modes included in the M channels of laser light is between 5% and 30%.

In an optional implementation of the fifth aspect, a quantity of modes of the equalized laser light is less than or equal to a quantity of modes of the laser light having the plurality of modes.

A sixth aspect of this application provides a laser light generation method. The laser light generation method includes the following steps: generating laser light including a plurality of modes; decomposing the laser light having the plurality of modes into X channels of laser light in different modes, where X is an integer greater than 1; reflecting the X channels of laser light, where the reflected X channels of laser light are used as an excitation source; transmitting the X channels of laser light; and outputting the transmitted X channels of laser light.

In an optional implementation of the sixth aspect, each of the X channels of laser light includes only one mode.

In an optional implementation of the sixth aspect, the laser light generation method includes the following steps: equalizing power of laser light in different modes in the laser light having the plurality of modes to obtain equalized laser light. The decomposing the laser light having the plurality of modes into X channels of laser light in different modes includes: decomposing the equalized laser light into the X channels of laser light in the different modes.

In an optional implementation of the sixth aspect, a quantity of modes of the equalized laser light is less than or equal to a quantity of modes of the laser light having the plurality of modes.

In an optional implementation of the sixth aspect, reflectivity of each of X Bragg gratings is between 5% and 30%.

**BRIEF DESCRIPTION OF DRAWINGS**

FIG. 1 is a diagram of a first structure of a multi-mode laser apparatus according to an embodiment of this application;
FIG. 2 is a diagram of a second structure of a multi-mode laser apparatus according to an embodiment of this application;
FIG. 3 is a diagram of a third structure of a multi-mode laser apparatus according to an embodiment of this application;
FIG. 4 is a diagram of a structure of an optical amplifier according to an embodiment of this application;
FIG. 5 is a diagram of a structure of an optical transmit module according to an embodiment of this application;
FIG. 6 is a first schematic flowchart of a laser light generation method according to an embodiment of this application; and
FIG. 7 is a second schematic flowchart of a laser light generation method according to an embodiment of this application.

## DESCRIPTION OF EMBODIMENTS

This application provides a multi-mode laser apparatus, an optical amplifier, and an optical transmit module. Multi-mode laser light can be decomposed into few-mode laser light or single-mode laser light by a mode demultiplexer. Therefore, in this application, wavelength locking and spectral bandwidth control on the multi-mode laser light can be implemented through a Bragg grating. It should be understood that "first", "second", and the like used in this application are merely used for distinguishing and description, but should not be understood as an indication or implication of relative importance or an indication or implication of a sequence. In addition, for brevity and clarity, reference numbers and/or letters are repeated in a plurality of accompanying drawings of this application. Repetition is not indicative of a strict limiting relationship between various embodiments and/or configurations.

The multi-mode laser apparatus provided in this application is applicable to the optical field, for example, the field of optical communications, optical display, or optical sensing. The multi-mode laser apparatus may generate high-power laser light through a multi-mode laser. However, in some application scenarios, there are high requirements on a center wavelength and a spectral bandwidth of laser light. Therefore, the wavelength locking and the spectral bandwidth control on the multi-mode laser light can be implemented using a waveguide taper technology. In the waveguide taper technology, a power loss of laser light in some modes occurs, resulting in low power utilization. Therefore, how to implement the wavelength locking and the spectral bandwidth control on the multi-mode laser light is a technical problem that needs to be urgently resolved currently.

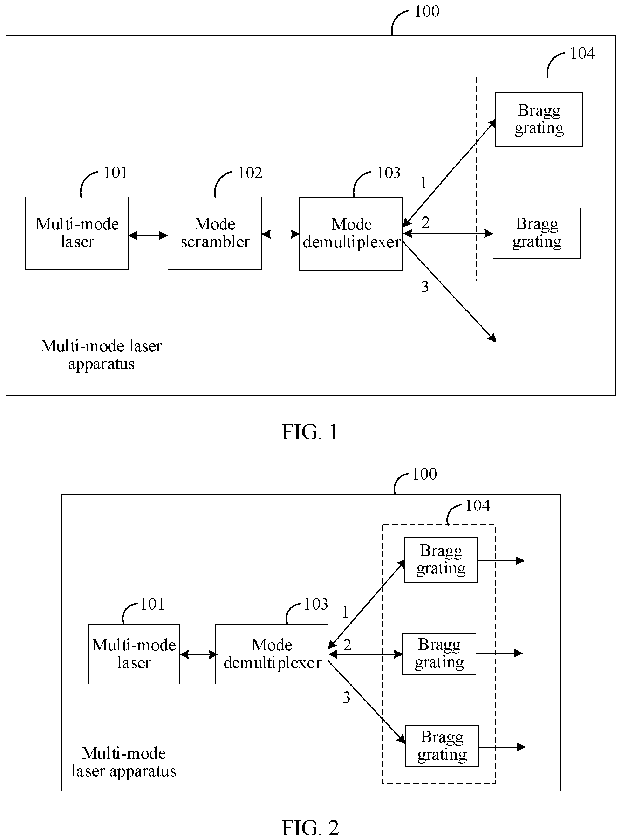

Therefore, in this application, the multi-mode laser apparatus is provided. FIG. 1 is a diagram of a first structure of a multi-mode laser apparatus according to an embodiment of this application. As shown in FIG. 1, the multi-mode laser apparatus 100 includes a multi-mode laser 101, a mode scrambler 102, a mode demultiplexer 103, and Y Bragg gratings 104.

The multi-mode laser 101 may be a semiconductor laser, an optical fiber laser, or the like. The multi-mode laser 101 is configured to: generate laser light having a plurality of modes, and transmit the laser light having the plurality of modes to the mode scrambler 102.

The mode scrambler 102 is configured to: equalize power of laser light in different modes in the laser light having the plurality of modes, and output equalized laser light. A quantity of modes of the laser light having the plurality of modes is also referred to as a quantity N1 of modes supported by the multi-mode laser 101. A quantity of modes of the equalized laser light is also referred to as a quantity N2 of modes supported by the mode scrambler 102. N1 and N2 are integers greater than 1. N1 and N2 may be the same or may be different. The mode scrambler 102 is further configured to transmit the equalized laser light to the mode demultiplexer 103.

The mode demultiplexer 103 is configured to decompose the equalized laser light into M channels of laser light in different modes. Each channel of laser light does not include laser light in a same mode. M is an integer greater than 1 and less than or equal to N2. Each of the M channels of laser light may have one or more modes. When M is equal to N2, each of the M channels of laser light includes one mode. When M is less than N2, the M channels of laser light include laser light having a plurality of modes. The mode demultiplexer 103 includes M output ports. X ports of the M output ports are configured to output X channels of laser light in the M channels of laser light. Y ports of the M output ports are configured to output Y channels of laser light in the M channels of laser light. X and Y are integers greater than 0 and less than M. For example, in FIG. 1, a value of M is 3, a value of Y is 2, and a value of X is 1. The Y ports include a port 1 and a port 2. The X ports include a port 3. The Y ports are connected to the Y Bragg gratings 104. The Y ports are in one-to-one correspondence with the Y Bragg gratings 104.

The Y Bragg gratings may be waveguide Bragg gratings. The Y Bragg gratings 104 are configured to reflect laser light of a specific wavelength in the Y channels of laser light, so as to implement wavelength locking. The Y Bragg gratings 104 are configured to transmit the reflected Y channels of laser light to the mode demultiplexer 103. The mode demultiplexer 103 is configured to combine the reflected Y channels of laser light to obtain combined laser light. The mode demultiplexer 103 is further configured to transmit the combined laser light to the mode scrambler 102. The mode scrambler 102 is further configured to obtain excitation laser light based on the combined laser light. After the laser light passes through the mode scrambler 102, the quantity of modes of the laser light changes. Specifically, a quantity of modes of the Y channels of laser light is less than N2. A quantity of modes of the excitation laser light is equal to N2. The mode scrambler 102 is further configured to transmit the excitation laser light to the multi-mode laser 101. The excitation laser light is used as an excitation source of the multi-mode laser 101. The multi-mode laser 101 is configured to generate the laser light having the plurality of modes based on the excitation laser light.

In this application, the multi-mode laser light may be decomposed into few-mode laser light or single-mode laser light by the mode demultiplexer. To be specific, each of the Y channels of laser light is few-mode laser light or single-mode laser light. Therefore, in this application, wavelength locking and spectral bandwidth control on the multi-mode laser light can be implemented through the Y Bragg gratings.

In FIG. 1, two devices may be connected through a waveguide. For example, the multi-mode laser 101 is connected to the mode scrambler 102 through a multi-mode waveguide, and the mode scrambler 102 is connected to the mode demultiplexer 103 through a multi-mode waveguide. The mode demultiplexer 103 is connected to the Y Bragg gratings 104 through a single-mode or few-mode waveguide.

It can be learned from the foregoing descriptions that each of the M channels of laser light has one or more modes. Therefore, each of the Y channels of laser light may include one or more modes. A reflection wavelength of the Bragg grating is related to a quantity of modes. When only one mode of laser light is reflected, the Bragg grating can stably control a wavelength of the reflected laser light, so that laser light with a narrow bandwidth is obtained. When laser light having a plurality of modes is reflected, it is difficult for the Bragg grating to control a wavelength of the reflected laser light, so that laser light with a wide bandwidth is obtained. Therefore, to obtain the laser light with a narrow bandwidth, each of the Y channels of laser light may include only one mode.

However, as N2 increases, to stabilize an output of the multi-mode laser 101, the value of Y also needs to increase. In this case, the multi-mode laser apparatus 100 needs more Bragg gratings, resulting in an increase in costs of the multi-mode laser apparatus 100. Therefore, when a value of N2 is greater than a first threshold, to reduce costs, Z may be greater than 1. Z is a quantity of modes of each of the Y channels of laser light. When the value of N2 is less than or equal to the first threshold, Z is equal to 1. In an example, the first threshold may be equal to 50.

It can be learned from the foregoing descriptions that, when the value of N2 is large, Z may be greater than 1. During actual application, a reflection wavelength of the Bragg grating is in positive correlation with a quantity of modes. When a quantity of modes of reflected laser light is larger, it is more difficult for the Bragg grating to control a wavelength of the reflected laser light, so that laser light with a wider bandwidth is obtained. Therefore, to obtain laser light that meets a bandwidth requirement, a value range of Z may be between 2 and 10. For example, Z may be equal to 2 or 10.

It can be learned from the foregoing descriptions that each of the M channels of laser light has one or more modes. Therefore, each of the X channels of laser light may include one or more modes. During actual application, there are many demands for single-mode laser light. Therefore, when each of the X channels of laser light includes a plurality of modes, the multi-mode laser apparatus 100 may further need to decompose the laser light having the plurality of modes into laser light in a single mode through another mode demultiplexer, resulting in an increase in costs of the multi-mode laser apparatus 100. Therefore, to reduce the costs of the multi-mode laser apparatus 100, each of the X channels of laser light may include only one mode.

In FIG. 1, the Y Bragg gratings are configured to reflect the Y channels of laser light. During actual application, the Y Bragg gratings may be further configured to transmit one or more of the Y channels of laser light. For example, when the Y Bragg gratings are configured to transmit the Y channels of laser light, the Y Bragg gratings are further configured to output the transmitted Y channels of laser light. In this case, the multi-mode laser apparatus 100 is configured to output (X+Y) channels of laser light.

In FIG. 1, when the Y Bragg gratings may be further configured to transmit one or more of the Y channels of laser light, power of the laser light reflected by the Y Bragg gratings decreases. To compensate for the decreased power, the value of Y may be increased. In this case, the multi-mode laser apparatus 100 needs more Bragg gratings, resulting in an increase in costs of the multi-mode laser apparatus 100. Therefore, the Y Bragg gratings may be highly reflective gratings. Reflectivity of the highly reflective grating is greater than 90%. Therefore, in this embodiment of this application, a quantity of the Bragg gratings can be reduced, thereby reducing costs of the multi-mode laser apparatus 100.

In FIG. 1, the X ports of the M output ports of the mode demultiplexer 103 are configured to output the X channels of laser light. During actual application, the X ports may alternatively be connected to one or more Bragg gratings. For example, the X ports are connected to X Bragg gratings. The X ports are in one-to-one correspondence with the X Bragg gratings. The X Bragg gratings are configured to reflect the X channels of laser light to obtain the reflected X channels of laser light. The reflected X channels of laser light are used as an excitation source of the multi-mode laser 101. For descriptions of the reflected X channels of laser light, refer to the foregoing descriptions of the reflected Y channels of laser light. The X Bragg gratings are further configured to transmit the X channels of laser light to obtain the transmitted X channels of laser light. The X Bragg gratings are further configured to output the transmitted X channels of laser light.

During actual application, the multi-mode laser 101 needs to ensure power of the excitation source, so that the laser light can be stably output. Therefore, in this embodiment of this application, the power of the excitation source can be controlled by controlling the quantity of modes included in the Y channels of laser light. Specifically, a ratio of the quantity of modes included in the Y channels of laser light to a quantity of modes included in the M channels of laser light may be between 5% and 30%. For example, the ratio is 5% or 30%.

It can be learned from the descriptions of FIG. 1 that the quantity N2 of modes supported by the mode scrambler 102 may be greater than the quantity N1 of modes supported by the multi-mode laser 101. In addition, the excitation laser light transmitted by the mode scrambler 102 to the multi-mode laser 101 includes N2 modes. If N2 is greater than N1, the multi-mode laser 101 wastes power of laser light in some modes. Therefore, to improve power utilization, the quantity of modes of the equalized laser light may be less than or equal to the quantity of modes of the laser light having the plurality of modes, that is, N2 is less than or equal to N1.

FIG. 2 is a diagram of a second structure of a multi-mode laser apparatus according to an embodiment of this application. As shown in FIG. 2, the multi-mode laser apparatus 100 includes a multi-mode laser 101, a mode demultiplexer 103, and X Bragg gratings 104.

The multi-mode laser 101 is configured to: generate laser light including a plurality of modes, and transmit the laser light having the plurality of modes to the mode demultiplexer 103. A quantity of modes of the laser light having the plurality of modes is also referred to as a quantity N1 of modes supported by the multi-mode laser 101.

The mode demultiplexer 103 is configured to decompose the laser light having the plurality of modes into X channels of laser light in different modes. X is an integer greater than 1. Each of the X channels of laser light may have one or more modes. When X is equal to N1, each of the X channels of laser light includes one mode. When X is less than N1, the X channels of laser light include laser light having a plurality of modes. The mode demultiplexer 103 includes X ports. For example, in FIG. 2, a value of X is 3. The X ports include a port 1, a port 2, and a port 3. The X ports are configured to output the X channels of laser light. The X ports are connected to the X Bragg gratings 104. The X ports are in one-to-one correspondence with the X Bragg gratings 104.

The X Bragg gratings 104 are configured to: reflect the X channels of laser light, and transmit the reflected X channels of laser light to the mode demultiplexer 103. The mode demultiplexer 103 is further configured to combine the reflected X channels of laser light to obtain excitation laser light. The mode demultiplexer 103 is further configured to transmit the excitation laser light to the multi-mode laser 101. The excitation laser light is used as an excitation source of the multi-mode laser 101. The multi-mode laser 101 is configured to generate the laser light having the plurality of modes based on the excitation laser light. The X Bragg gratings 104 are further configured to: transmit the X channels of laser light, and output the transmitted X channels of laser light. In this embodiment of this application, wavelength locking and spectral bandwidth control on the X channels of laser light can be implemented through the X Bragg gratings.

During actual application, the multi-mode laser 101 needs to ensure power of the excitation source, so that the laser light can be stably output. Therefore, in this embodiment of this application, the power of the excitation source can be controlled by controlling reflectivity of the X Bragg gratings 104. Specifically, reflectivity of each of the X Bragg gratings may be between 5% and 30%. For example, the reflectivity of each Bragg grating is 5% or 30%.

In FIG. 2, each of the X channels of laser light may have one or more modes. During actual application, there are many demands for single-mode laser light.

Therefore, when each of the X channels of laser light includes a plurality of modes, the multi-mode laser apparatus 100 may further need to decompose the laser light having the plurality of modes into laser light in a single mode through another mode demultiplexer, resulting in an increase in costs of the multi-mode laser apparatus 100. Therefore, to reduce the costs of the multi-mode laser apparatus 100, each of the X channels of laser light may include only one mode.

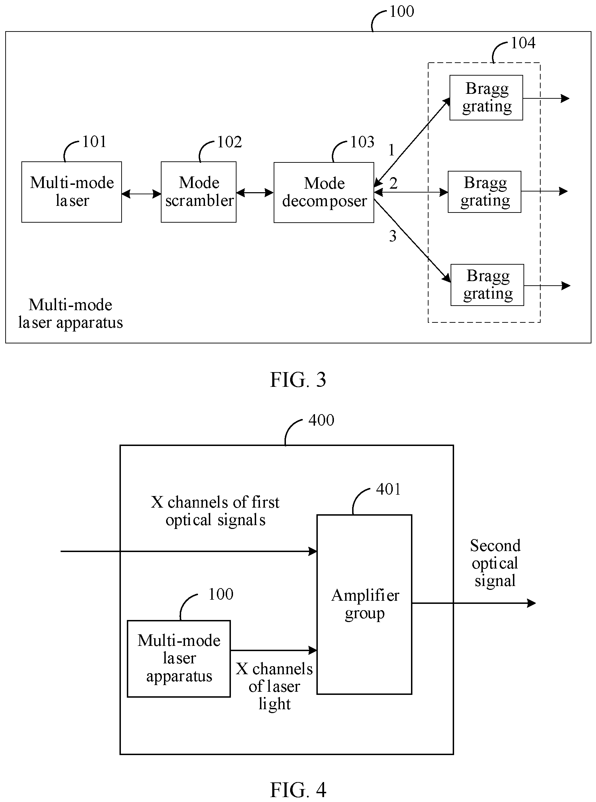

During actual application, due to a process limitation, power of the laser light in different modes in the laser light having the plurality of modes output by the multi-mode laser 101 may be different. In this case, the transmitted X channels of laser light also have different power, resulting in a reduction in quality of the output laser light. Therefore, the multi-mode laser apparatus 100 may further include a mode scrambler. FIG. 3 is a diagram of a third structure of a multi-mode laser apparatus according to an embodiment of this application. As shown in FIG. 3, based on FIG. 2, the multi-mode laser apparatus 100 further includes a mode scrambler 102. A multi-mode laser 101 is configured to transmit laser light having a plurality of modes to the mode scrambler 102. The mode scrambler 102 is configured to: equalize power of laser light in different modes in the laser light having the plurality of modes, and output equalized laser light. The mode scrambler 102 is configured to transmit the equalized laser light to a mode demultiplexer 103. For descriptions of the mode scrambler 102, refer to related descriptions in FIG. 1. Use of the mode scrambler 102 can equalize the power of the laser light in the different modes in the laser light having the plurality of modes, so as to equalize power of transmitted X channels of laser light and improve quality of output laser light.

The multi-mode laser apparatus provided in this application is described above. The following describes an optical amplifier provided in this application. FIG. 4 is a diagram of a structure of an optical amplifier according to an embodiment of this application. As shown in FIG. 4, the optical amplifier 400 includes an amplifier group 401 and a multi-mode laser apparatus 100. For descriptions of the multi-mode laser apparatus 100, refer to related descriptions of any one of the foregoing FIG. 1 to FIG. 3. The multi-mode laser apparatus 100 is configured to: output X channels of laser light to the amplifier group 401, and provide pump light for the amplifier group 401. X is an integer greater than 0. The amplifier group 401 includes P amplifiers. P is an integer less than or equal to X and greater than or equal to $\frac{X}{2}$. The P amplifiers are configured to: receive X channels of first optical signals and the X channels of laser light, and amplify the X channels of first optical signals based on the X channels of laser light to obtain X channels of second optical signals. Each of the P amplifiers corresponds to one or two channels of laser light. The X channels of laser light are in one-to-one correspondence with the X channels of first optical signals. The X channels of first optical signals are in one-to-one correspondence with the X channels of second optical signals.

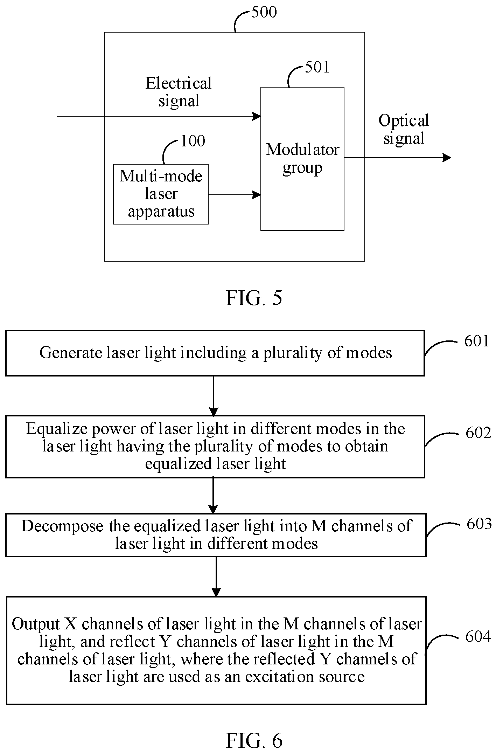

FIG. 5 is a diagram of a structure of an optical transmit module according to an embodiment of this application. As shown in FIG. 5, the optical transmit module 500 includes a modulator group 501 and a multi-mode laser apparatus 100. For descriptions of the multi-mode laser apparatus 100, refer to related descriptions of any one of the foregoing FIG. 1 to FIG. 3. The multi-mode laser apparatus 100 is configured to output X channels of laser light to the modulator group 501, and provide a to-be-modulated beam to the modulator group 501. X is an integer greater than 0. The modulator group 501 includes X modulators. The X modulators are in one-to-one correspondence with the X channels of laser light. The X modulators are configured to modulate the X channels of laser light based on an electrical signal to obtain X channels of optical signals. The X channels of laser light are in one-to-one correspondence with the X channels of optical signals. The X modulators may be configured to modulate the X channels of laser light based on X channels of electrical signals to obtain the X channels of optical signals. The X channels of electrical signals are in one-to-one correspondence with the X channels of laser light.

The following describes a laser light generation method provided in this application. FIG. 6 is a first schematic flowchart of a laser light generation method according to an embodiment of this application. As shown in FIG. 6, the laser light generation method includes the following steps.

Step 601: Generate laser light including a plurality of modes. For example, the laser light having the plurality of modes may be generated by a multi-mode laser. The multi-mode laser may be a semiconductor laser, an optical fiber laser, or the like.

Step 602: Equalize power of laser light in different modes in the laser light having the plurality of modes to obtain equalized laser light. For example, the power of the laser light in the different modes in the laser light having the plurality of modes may be equalized by a mode scrambler 102. A quantity N1 of modes of the laser light having the plurality of modes may be the same as or different from a quantity N2 of modes of the equalized laser light. N1 and N2 are integers greater than 1.

Step 603: Decompose the equalized laser light into M channels of laser light in different modes. M is an integer greater than 1. For example, the equalized laser light may be decomposed into the M channels of laser light in the different modes by a mode demultiplexer. Each of the M channels of laser light may have one or more modes. When M is equal to N2, each of the M channels of laser light includes one mode. When M is less than N2, the M channels of laser light include laser light having a plurality of modes.

Step 604: Output X channels of laser light in the M channels of laser light, and reflect Y channels of laser light in the M channels of laser light, where the reflected Y channels of laser light are used as an excitation source. When the equalized laser light is decomposed into the M channels of laser light in the different modes by the mode demultiplexer, the mode demultiplexer includes X ports and Y ports. The X ports are in one-to-one correspondence with the X channels of laser light. The Y ports are in one-to-one correspondence with the Y channels of laser light. X and Y are integers greater than 0. The Y ports are connected to Y reflectors. The reflectors may be Bragg gratings. The Y reflectors are in one-to-one correspondence with the Y ports. The Y channels of laser light are reflected by the Y reflectors. The reflected Y channels of laser light are used as the excitation source for generating the laser light having the plurality of modes.

It should be understood that, for descriptions of the laser light generation method, reference may be made to the foregoing descriptions of the multi-mode laser apparatus in FIG. 1. For example, during actual application, to improve power utilization, N2 may be less than or equal to N1. For another example, each of the M channels of laser light may include laser light in only one mode. For another example, a ratio of a quantity of modes included in the Y channels of laser light to a quantity of modes included in the M channels of laser light may be between 5% and 30%.

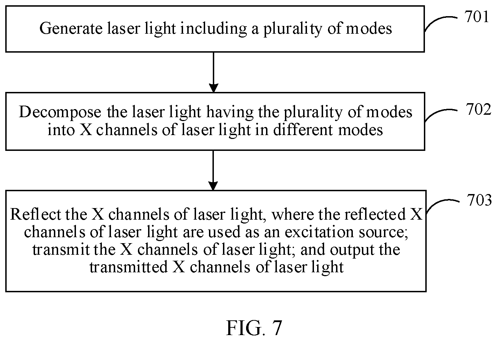

FIG. 7 is a second schematic flowchart of a laser light generation method according to an embodiment of this application. As shown in FIG. 7, the laser light generation method includes the following steps.

Step 701: Generate laser light including a plurality of modes.

Step 702: Decompose the laser light having the plurality of modes into X channels of laser light in different modes. X is an integer greater than 1. For example, the laser light having the plurality of modes may be decomposed into the X channels of laser light in the different modes by a mode demultiplexer. Each of the X channels of laser light may have one or more modes. A quantity of modes of the laser light having plurality of modes is N1. When X is equal to N1, each of the X channels of laser light includes one mode. When X is less than N1, the X channels of laser light include laser light having a plurality of modes.

Step 703: Reflect the X channels of laser light, where the reflected X channels of laser light are used as an excitation source; transmit the X channels of laser light; and output the transmitted X channels of laser light. When the laser light having the plurality of modes are decomposed into the X channels of laser light in the different modes by the mode demultiplexer, the mode demultiplexer includes X ports. The X ports are connected to X reflectors. The reflectors may be Bragg gratings. The X reflectors are in one-to-one correspondence with the X ports. The X channels of laser light are reflected by the X reflectors. The reflected X channels of laser light are used as the excitation source for generating the laser light having the plurality of modes. The X channels of laser light are transmitted by the X reflectors to obtain the transmitted X channels of laser light.

It should be understood that, for descriptions of the laser light generation method, reference may be made to the foregoing descriptions of the multi-mode laser apparatus in FIG. 2 or FIG. 3. For example, the laser light generation method further includes the following step: equalizing power of laser light in different modes in the laser light having the plurality of modes to obtain equalized laser light; and decomposing the equalized laser light into the X channels of laser light in the different modes. For another example, a quantity of modes of the equalized laser light is less than or equal to a quantity of modes of the laser light having the plurality of modes. For another example, each of the X channels of laser light includes only one mode.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

**Claims**

1. A multi-mode laser apparatus, comprising a multi-mode laser, a mode scrambler, a mode demultiplexer, and Y Bragg gratings, wherein

the multi-mode laser is configured to generate laser light comprising a plurality of modes;
the mode scrambler is configured to: equalize power of laser light in different modes in the laser light having the plurality of modes, and output equalized laser light;
the mode demultiplexer is configured to decompose the equalized laser light into M channels of laser light in different modes, M is an integer greater than 1, the mode demultiplexer comprises M output ports, X ports of the M output ports are configured to output X channels of laser light in the M channels of laser light, Y ports of the M output ports are configured to output Y channels of laser light in the M channels of laser light, X and Y are integers greater than 0, the Y ports are connected to the Y Bragg gratings, and the Y ports are in one-to-one correspondence with the Y Bragg gratings;
the Y Bragg gratings are configured to: reflect the Y channels of laser light, and transmit the reflected Y channels of laser light to the mode demultiplexer;
the mode demultiplexer is further configured to transmit the reflected Y channels of laser light to the mode scrambler; and
the mode scrambler is further configured to: obtain excitation laser light based on the reflected Y channels of laser light, and transmit the excitation laser light to the multi-mode laser, wherein the excitation laser light is used as an excitation source of the multi-mode laser.

2. The multi-mode laser apparatus according to claim 1, wherein each of the Y channels of laser light comprises Z modes, and Z is an integer greater than 1.

3. The multi-mode laser apparatus according to claim 2, wherein each of the X channels of laser light comprises only one mode.

4. The multi-mode laser apparatus according to claim 2 or 3, wherein Z is between 2 and 10.

5. The multi-mode laser apparatus according to claim 1, wherein each of the M channels of laser light comprises only one mode.

6. The multi-mode laser apparatus according to any one of claims 1 to 5, wherein a ratio of a quantity of modes comprised in the Y channels of laser light to a quantity of modes comprised in the M channels of laser light is between 5% and 30%.

7. The multi-mode laser apparatus according to any one of claims 1 to 6, wherein a quantity of modes of the equalized laser light is less than or equal to a quantity of modes of the laser light having the plurality of modes.

8. The multi-mode laser apparatus according to any one of claims 1 to 7, wherein the Y Bragg gratings are waveguide Bragg gratings.

9. The multi-mode laser apparatus according to any one of claims 1 to 8, wherein reflectivity of each of the Y Bragg gratings is greater than 90%.

10. A multi-mode laser apparatus, comprising a multi-mode laser, a mode demultiplexer, and X Bragg gratings, wherein

the multi-mode laser is configured to generate laser light comprising a plurality of modes;
the mode demultiplexer is configured to decompose the laser light having the plurality of modes into X channels of laser light in different modes, X is an integer greater than 1, the mode demultiplexer comprises X ports, the X ports are configured to output the X channels of laser light, the X ports are connected to the X Bragg gratings, and the X ports are in one-to-one correspondence with the X Bragg gratings;
the X Bragg gratings are configured to: reflect the X channels of laser light, and transmit the reflected X channels of laser light to the mode demultiplexer, and the X Bragg gratings are further configured to: transmit the X channels of laser light, and output the transmitted X channels of laser light; and

the mode demultiplexer is further configured to: combine the reflected X channels of laser light to obtain excitation laser light, and transmit the excitation laser light to the multi-mode laser, wherein the excitation laser light is used as an excitation source of the multi-mode laser.

11. The multi-mode laser apparatus according to claim 10, wherein each of the X channels of laser light comprises only one mode.

12. The multi-mode laser apparatus according to claim 10 or 11, wherein the apparatus further comprises a mode scrambler, and

the mode scrambler is configured to: equalize power of laser light in different modes in the laser light having the plurality of modes, and output equalized laser light;

that the mode demultiplexer is configured to decompose the laser light having the plurality of modes into X channels of laser light in different modes comprises: the mode demultiplexer is configured to decompose the equalized laser light into the X channels of laser light in the different modes; and

that the mode demultiplexer is further configured to transmit the excitation laser light to the multi-mode laser comprises: the mode demultiplexer is further configured to transmit the excitation laser light to the multi-mode laser through the mode scrambler.

13. The multi-mode laser apparatus according to claim 12, wherein a quantity of modes of the equalized laser light is less than or equal to a quantity of modes of the laser light having the plurality of modes.

14. The multi-mode laser apparatus according to any one of claims 10 to 13, wherein reflectivity of each of the X Bragg gratings is between 5% and 30%.

15. An optical amplifier, comprising an amplifier group and the multi-mode laser apparatus according to any one of claims 1 to 14, wherein

the multi-mode laser apparatus is configured to output X channels of laser light, and X is an integer greater than 0; and

the amplifier group comprises P amplifiers, P is an integer less than or equal to X and greater than or equal to $\frac{X}{2}$, and the P amplifiers are configured to: receive X channels of first optical signals and the X channels of laser light, and amplify the X channels of first optical signals based on the X channels of laser light to obtain X channels of second optical signals.

16. An optical transmit module, comprising a modulator group and the multi-mode laser apparatus according to any one of claims 1 to 14, wherein

the multi-mode laser apparatus is configured to output X channels of laser light, and X is an integer greater than 0; and

the modulator group comprises X modulators, the X modulators are in one-to-one correspondence with the X channels of laser light, and the X modulators are configured to modulate the X channels of laser light based on an electrical signal to obtain X channels of optical signals.

17. A laser light generation method, comprising:

generating laser light comprising a plurality of modes;

equalizing power of laser light in different modes in the laser light having the plurality of modes to obtain equalized laser light;

decomposing the equalized laser light into M channels of laser light in different modes, wherein M is an integer greater than 1;

outputting X channels of laser light in the M channels of laser light; and

reflecting Y channels of laser light in the M channels of laser light, wherein the reflected Y channels of laser light are used as an excitation source, and X and Y are integers greater than 0.

18. The method according to claim 17, wherein each of the Y channels of laser light comprises Z modes, and Z is an integer greater than 1.

19. The method according to claim 17, wherein each of the M channels of laser light comprises only one mode.

FIG. 1

FIG. 2

FIG. 3

FIG. 4

~500

Electrical
signal

~501

~100

| Multi-mode laser apparatus |

| Modulator group |

Optical signal

**FIG. 5**

| Generate laser light including a plurality of modes | ~ 601 |

| Equalize power of laser light in different modes in the laser light having the plurality of modes to obtain equalized laser light | ~ 602 |

| Decompose the equalized laser light into M channels of laser light in different modes | ~ 603 |

| Output X channels of laser light in the M channels of laser light, and reflect Y channels of laser light in the M channels of laser light, where the reflected Y channels of laser light are used as an excitation source | ~ 604 |

**FIG. 6**

Generate laser light including a plurality of modes    701

Decompose the laser light having the plurality of modes into X channels of laser light in different modes    702

Reflect the X channels of laser light, where the reflected X channels of laser light are used as an excitation source; transmit the X channels of laser light; and output the transmitted X channels of laser light    703

FIG. 7

<div align="center">**INTERNATIONAL SEARCH REPORT**</div>

| International application No. |
| --- |
| **PCT/CN2023/092946** |

**A.  CLASSIFICATION OF SUBJECT MATTER**

H01S5/065(2006.01)i;  H01S3/09(2006.01)i

According to International Patent Classification (IPC) or to both national classification and IPC

**B.  FIELDS SEARCHED**

Minimum documentation searched (classification system followed by classification symbols)

IPC:H01S1/-、H01S3/-;  CPC：H01S5/0651、H01S5/0656、H01S5/0657

Documentation searched other than minimum documentation to the extent that such documents are included in the fields searched

Electronic data base consulted during the international search (name of data base and, where practicable, search terms used)

CNABS, CNTXT, ENTXTC, WPABSC, VEN, ENTXT, CNKI, IEEE: 华为, 刘沛, 张楷, 吴波, 布拉格光栅, 多模, 反射, 波长锁定, 带宽, 激励, 解复用, 扰模, 扰频, 扰匀, 放大器, FBG, Bragg fiber, reflect+, mode scrambler, multi 1w mode, wavelength lock+, bandwidth, demultipleser, laser amplifier

**C.  DOCUMENTS CONSIDERED TO BE RELEVANT**

| Category* | Citation of document, with indication, where appropriate, of the relevant passages | Relevant to claim No. |
| --- | --- | --- |
| A | CN 103701024 A (ACCELINK TECHNOLOGIES CO., LTD.) 02 April 2014 (2014-04-02) entire document | 1-19 |
| A | CN 114080738 A (FUJIKURA LTD.) 22 February 2022 (2022-02-22) entire document | 1-19 |
| A | CN 1328729 A (ERICSSON TELEFON AB. L. M.) 26 December 2001 (2001-12-26) entire document | 1-19 |
| A | CN 207217993 U (UNIVERSITY OF SCIENCE AND TECHNOLOGY OF CHINA) 10 April 2018 (2018-04-10) entire document | 1-19 |
| A | JP 2021163814 A (FURUKAWA ELECTRIC CO., LTD.) 11 October 2021 (2021-10-11) entire document | 1-19 |
| A | US 2006013527 A1 (BAE SYSTEMS INFORMATION AND ELECTRONIC SYSTEMS INTEGRATION INC.) 19 January 2006 (2006-01-19) entire document | 1-19 |

[✓] Further documents are listed in the continuation of Box C.     [✓] See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **25 July 2023** | **04 August 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/092946** |

**C.    DOCUMENTS CONSIDERED TO BE RELEVANT**

| Category* | Citation of document, with indication, where appropriate, of the relevant passages | Relevant to claim No. |
|---|---|---|
| A | US 2015207296 A1 (ROCKLEY PHOTONICS LIMITED) 23 July 2015 (2015-07-23)<br>    entire document | 1-19 |
| A | CN 107069425 A (INSTITUTE OF SEMICONDUCTORS, CHINESE ACADEMY OF SCIENCES) 18 August 2017 (2017-08-18)<br>    entire document | 1-19 |
| A | 孙明星 (SUN, Mingxing). "基于全光纤拉锥滤波结构的波长可切换掺铒光纤激光器 (Wavelength Switchable Erbium-Doped Fiber Laser Based on All Fiber Taper Filter Structure)"<br>光通信技术 (Optical Communication Technology),<br>No. 9, 30 September 2020 (2020-09-30), pages 37-41<br>    pages 37-41 | 1-19 |

Form PCT/ISA/210 (second sheet) (July 2022)

<table>
<tr><td colspan="2" align="center">**INTERNATIONAL SEARCH REPORT**<br>**Information on patent family members**</td><td colspan="2">International application No.<br><br>**PCT/CN2023/092946**</td></tr>
</table>

| Patent document cited in search report | | | Publication date (day/month/year) | Patent family member(s) | | | Publication date (day/month/year) |
|---|---|---|---|---|---|---|---|
| CN | 103701024 | A | 02 April 2014 | CN | 103701024 | B | 25 July 2017 |
| CN | 114080738 | A | 22 February 2022 | JP | 6731099 | B1 | 29 July 2020 |
| | | | | JP | 2021022622 | A | 18 February 2021 |
| | | | | WO | 2021014895 | A1 | 28 January 2021 |
| | | | | US | 2022255287 | A1 | 11 August 2022 |
| CN | 1328729 | A | 26 December 2001 | TW | 393844 | B | 11 June 2000 |
| | | | | JP | 2002528956 | A | 03 September 2002 |
| | | | | HK | 1042999 | B | 10 December 2004 |
| | | | | KR | 20010075468 | A | 09 August 2001 |
| | | | | KR | 100589838 | B1 | 14 June 2006 |
| | | | | US | 6452718 | B1 | 17 September 2002 |
| | | | | AU | 1193000 | A | 08 May 2000 |
| | | | | WO | 0024148 | A1 | 27 April 2000 |
| | | | | SE | 513096 | C2 | 10 July 2000 |
| | | | | EP | 1118181 | A1 | 25 July 2001 |
| | | | | CA | 2343822 | A1 | 27 April 2000 |
| | | | | SE | 9803348 | A | 03 April 2000 |
| CN | 207217993 | U | 10 April 2018 | CN | 107370015 | A | 21 November 2017 |
| JP | 2021163814 | A | 11 October 2021 | None | | | |
| US | 2006013527 | A1 | 19 January 2006 | WO | 2006019598 | A2 | 23 February 2006 |
| | | | | WO | 2006019598 | A3 | 20 April 2006 |
| | | | | US | 7197209 | B2 | 27 March 2007 |
| US | 2015207296 | A1 | 23 July 2015 | GB | 2522410 | A | 29 July 2015 |
| | | | | US | 9240673 | B2 | 19 January 2016 |
| | | | | WO | 2015107365 | A1 | 23 July 2015 |
| | | | | CN | 106068586 | B | 19 September 2017 |
| | | | | CN | 106068586 | A | 02 November 2016 |
| | | | | GB | 2522410 | B | 07 October 2020 |
| CN | 107069425 | A | 18 August 2017 | CN | 107069425 | B | 20 August 2019 |

Form PCT/ISA/210 (patent family annex) (July 2022)

**REFERENCES CITED IN THE DESCRIPTION**

**Patent documents cited in the description**

- CN 202210504349